# EUROPEAN PATENT APPLICATION

(11) **EP 2 071 400 A1**
(43) Date of publication of application: **17.06.2009**
(21) Application number: 08168807.9
(22) Date of filing: 11.11.2008
(51) Int. Cl.: G03F 7/075, G03F 7/09

(54) **Coating compositions for use with an overcoated photoresist**

(30) Priority: 12.11.2007 US 2872 P
(71) Applicant: Rohm and Haas Electronic Materials LLC, Marlborough, MA 01752 (US)
(72) Inventor: Amara, John P, Charlestown, MA 02139 (US); Pugliano, Nicola, Grafton, MA 01519 (US); Sung, Jin Wuk, Worcester, MA 01605 (US); Gallagher, Michael K, Hopkington, MA 01748 (US); Castorano, Michael S, Leominster, MA 01453 (US)
(74) Representative: Buckley, Guy Julian

(57) **Abstract**

In one aspect, the invention relates to silicon-containing organic coating compositions, particularly antireflective coating compositions, that contain a repeat unit wherein chromophore moieties such as phenyl are spaced from Si atom(s). In another aspect, silicon-containing underlayer compositions are provided that are formulated as a liquid (organic solvent) composition, where at least one solvent of the solvent component comprise hydroxy groups.

## Description

The present application claims the benefit of U.S. provisional application number 61/002,872, filed November 12, 2007, which is incorporated by reference herein in its entirety.

The present invention relates to compositions (particularly antireflective coating compositions or "ARCs") that can reduce reflection of exposing radiation from a substrate back into an overcoated photoresist layer and/or function as a planarizing or via-fill layer. More particularly, in one aspect, the invention relates to silicon-containing organic coating compositions, particularly antireflective coating compositions, that contain a repeat unit wherein chromophore moieties such as phenyl are spaced from Si atom(s).

Photoresists are photosensitive films used for the transfer of images to a substrate. A coating layer of a photoresist is formed on a substrate and the photoresist layer is then exposed through a photomask to a source of activating radiation. The photomask has areas that are opaque to activating radiation and other areas that are transparent to activating radiation. Exposure to activating radiation provides a photoinduced or chemical transformation of the photoresist coating to thereby transfer the pattern of the photomask to the photoresist-coated substrate. Following exposure, the photoresist is developed to provide a relief image that permits selective processing of a substrate.

A major use of photoresists is in semiconductor manufacture where an object is to convert a highly polished semiconductor slice, such as silicon or gallium arsenide, into a complex matrix of electron conducting paths that perform circuit functions. Proper photoresist processing is a key to attaining this object. While there is a strong interdependency among the various photoresist processing steps, exposure is believed to be one of the most important steps in attaining high resolution photoresist images.

Reflection of activating radiation used to expose a photoresist often poses limits on resolution of the image patterned in the photoresist layer. Reflection of radiation from the substrate/photoresist interface can produce spatial variations in the radiation intensity in the photoresist, resulting in non-uniform photoresist linewidth upon development. Radiation also can scatter from the substrate/photoresist interface into regions of the photoresist where exposure is non-intended, again resulting in linewidth variations.

One approach used to reduce the problem of reflected radiation has been the use of a radiation absorbing layer interposed between the substrate surface and the photoresist coating layer. See for example U.S. 2004/0229158.

It would be desirable to have improved photoresist systems.

We have found that prior silicon-containing antireflective underlayer compositions may exhibit poor lithographic performance including in 193 nm imaging.

Without being bound by theory, we postulate that residual silanol groups in a cured silsesquioxane antireflective underlayer may serve as acidic sites that promote quencher base migration from the over-coated photoresist film. As a result, the photoresist layer becomes depleted in quencher base, resulting in significantly faster photospeeds. The ratio of photo-acid generator (PAG) to quencher base can be very important, since resist deprotection reactions are dependent on catalytic amounts of photo-generated acid. The quencher base concentration can control the extent of the catalytic deprotection reactions. Changes in the concentration or distribution of the quencher in the photoresist film can influence resist performance or feature profiles and can lead to pattern collapse or resist failure.

We now provide new silicon resins and photoresist compositions that can avoid undesired increases in photoresist photospeed. In particular, it is believed that preferred silicon compositions of the invention can be cured to provide an underlayer that is less prone to depletion of base quencher of an overcoated photoresist layer. It is believed that preferred silicon compositions of the invention can be cured to provide a reduced content of acidic silanol groups which will result in less depletion of base from an overcoated photoresist layer.

In one aspect, silicon resins are provided that are obtainable by reaction of one or more compounds that have a silicon atoms spaced by one or two or more carbon or hetero (N, O, S) atoms from the closest adjacent Si atom or aromatic moiety such as phenyl, naphthyl or anthracne. Preferably, such reagents have Si atoms spaced at least 2, 3, 4, 5, 6, 7 or 8 carbon or hetero (N, O, S) atoms from the closest adjacent Si atom or aromatic moiety. Specifically preferred reagents include e.g. aromatic(CH₂)₂₋₈Si(OC₁₋₈alkyl)₃ where aromatic preferably may be phenyl, naphthyl or anthracenyl, such as the compound phenethyltrimethoxysilane and phenethyltriethoxysilane (phenyl(CH₂)₂Si(OCH₃)₃ andphenyl(CH₂)₂Si(OCH₂CH₃)₃). Additionally preferred reagents include compounds without a an aromatic group, but multiple Si atoms, e.g. compounds such as ((OC₁₋₈alkyl)₃ Si(CH₂)₂₋₈Si(OC₁₋₈alkyl)₃ e.g. bistriethoxysilylethane and bistrimthoxysilylethane ((OCH₂CH₃)₃ Si(CH₂)₂₋₈Si(OCH₂CH₃)₃ and (OCH₃)₃ Si(CH₂)₂₋₈Si(OCH₃)₃).

In a further aspect, silicon-containing underlayer compositions are provided that are formulated as a liquid (organic solvent) composition, where at least one solvent of the solvent component comprise hydroxy groups. For example, suitable solvents include propylene glycol propyl ether (CH₃CH(OH)CH₂OCH₂CH₃) and ethyl lactate. It is believed that such solvents such alkoxylate silanol groups of the Si-resin and thereby resin the Si-underayer composition less prone to deplete base from an overcoated photoresist layer.

As indicated above, Si-underlayer compositions preferably comprise a component that comprises chromophore groups that can absorb undesired radiation used to expose the overcoated resist layer from reflecting back into the resist layer. Such chromophore groups may be present with other composition components such as the Si-resin(s), or the composition may comprise another component that may comprise such chromophore units, e.g. a small molecule (e.g. MW less than about 1000 or 500) that contains one or more chromophore moieties, such as one or more optionally substituted phenyl, optionally substituted anthracene or optionally substituted naphthyl groups.

Generally preferred chromophores for inclusion in coating composition of the invention particularly those used for antireflective applications include both single ring and multiple ring aromatic groups such as optionally substituted phenyl, optionally substituted naphthyl, optionally substituted anthracenyl, optionally substituted phenanthracenyl, optionally substituted quinolinyl, and the like. Particularly preferred chromophores may vary with the radiation employed to expose an overcoated resist layer. More specifically, for exposure of an overcoated resist at 248 nm, optionally substituted anthracene and optionally substituted naphthyl are preferred chromophores of the antireflective composition. For exposure of an overcoated resist at 193 nm, optionally substituted phenyl and optionally substituted naphthyl are particularly preferred chromophores of the antireflective composition. Preferably, such chromophore groups are linked (e.g. pendant groups) to a resin component of the antireflective composition.

As discussed above, Si-coating compositions of the invention preferably are crosslinking compositions and contain a material that will crosslink or otherwise cure upon e.g. thermal or activating radiation treatment. Typically, the composition will contain a crosslinker component, e.g. an amine-containing material such as a melamine, glyocouril or benzoguanamine compound or resin.

Preferably, crosslinking compositions of the invention can be cured through thermal treatment of the composition coating layer. Suitably, the coating composition also contains an acid or more preferably an acid generator compound, particularly a thermal acid generator compound, to facilitate the crosslinking reaction.

For use as an antireflective coating composition, as well as other applications such as via-fill, preferably the composition is crosslinked prior to applying a photoresist composition layer over the composition layer.

Coating compositions of the invention are typically formulated and applied to a substrate as an organic solvent solution, suitably by spin-coating (i.e. a spin-on composition).

A variety of photoresists may be used in combination (i.e. overcoated) with a coating composition of the invention. Preferred photoresists for use with the antireflective compositions of the invention are chemically-amplified resists, especially positive-acting photoresists that contain one or more photoacid generator compounds and a resin component that contains units that undergo a deblocking or cleavage reaction in the presence of photogenerated acid, such as photoacid-labile ester, acetal, ketal or ether units. Negative-acting photoresists also can be employed with coating compositions of the invention, such as resists that crosslink (i.e. cure or harden) upon exposure to activating radiation. Preferred photoresists for use with a coating composition of the invention may be imaged with relatively short-wavelength radiation, e.g. radiation having a wavelength of less than 300 nm or less than 260 nm such as 248 nm, or radiation having a wavelength of less than about 200 nm such as 193 nm.

The invention further provides methods for forming a photoresist relief image and novel articles of manufacture comprising substrates (such as a microelectronic wafer substrate) coated with a coating composition of the invention alone or in combination with a photoresist composition.

Other aspects of the invention are disclosed infra.

We now provide new silicon coating compositions that are particularly useful with an overcoated photoresist layer. These coating composition preferable comprise an organic silicon resin, e.g. an organic silsesquioxane resin. Preferred coating compositions of the invention may be applied by spin-coating (spin-on compositions) and formulated as a solvent composition. The coating compositions of the invention are especially useful as antireflective compositions for an overcoated photoresist and/or as planarizing or via-fill compositions for an overcoated photoresist composition coating layer.

### Underlying coating compositions:

Organic polysilica antireflective layers can be deposited on a dielectric material including the steps of: a) disposing a antireflective layer composition on a dielectric material, the antireflective layer composition including one or more B-staged organic polysilica resins and one or more coating enhancers; and b) at least partially curing the one or more B-staged organic polysilica resins to form a antireflective layer

Preferred antireflective layer compositions include one or more B-staged organic polysilica resins and one or more coating enhancers. By "organic polysilica resin" (or organo siloxane) is meant a compound including silicon, carbon, oxygen and hydrogen atoms. Exemplary organic polysilica resins are hydrolyzates and partial condensates of one or more silanes of formulae (I) or (II):

RₐSiY₄₋ₐ (I)

R¹_{b}(R²O)_{3-b}Si(R³)_{c}Si(OR⁴)_{3-d}R⁵_{d} (II)

wherein R is hydrogen, (C₁-C₈)alkyl, (C₇-C₁₂)arylalkyl, substituted (C₇-C₁₂)arylalkyl, aryl, and substituted aryl; Y is any hydrolyzable group; a is an integer of 0 to 2; R¹, R², R⁴ and R⁵ are independently selected from hydrogen, (C₁-C₆)alkyl, (C₇-C₁₂)arylalkyl, substituted (C₇-C₁₂)arylalkyl, aryl, and substituted aryl; R³ is selected from (C₁-C₁₀)alkyl, -(CH₂)ₕ-, -(CH₂)ₕ₁-Eₖ-(CH₂)ₕ₂-, -(CH₂)ₕ-Z, arylene, substituted arylene, and arylene ether; E is selected from oxygen, NR⁶ and Z; Z is selected from aryl and substituted aryl; R⁶ is selected from hydrogen, (C₁-C₆)alkyl, aryl and substituted aryl; b and d are each an integer of 0 to 2; c is an integer of 0 to 6; and h, h1, h2 and k are independently an integer from 1 to 6; provided that at least one of R, R¹, R³ and R⁵ is not hydrogen. "Substituted arylalkyl", "substituted aryl" and "substituted arylene" refer to an arylalkyl, aryl or arylene group having one or more of its hydrogens replaced by another substituent group, such as cyano, hydroxy, halo, (C₁-C₆)alkyl, (C₁-C₆)alkoxy, and the like.

It is preferred that R is (C₁-C₄)alkyl, benzyl, hydroxybenzyl, phenethyl or phenyl, and more preferably methyl, ethyl, iso-butyl, tert-butyl or phenyl. Preferably, a is 1. Suitable hydrolyzable groups for Y include, but are not limited to, halo, (C₁-C₆)alkoxy, acyloxy and the like. Preferred hydrolyzable groups are chloro and (C₁-C₂)alkoxy. Suitable organosilanes of formula (I) include, but are not limited to, methyl trimethoxysilane, methyl triethoxysilane, phenyl trimethoxysilane, phenyl triethoxysilane, tolyl trimethoxysilane, tolyl triethoxysilane, propyl tripropoxysilane, iso-propyl triethoxysilane, iso-propyl tripropoxysilane, ethyl trimethoxysilane, ethyl triethoxysilane, iso-butyl triethoxysilane, iso-butyl trimethoxysilane, tert-butyl triethoxysilane, tert-butyl trimethoxysilane, cyclohexyl trimethoxysilane, cyclohexyl triethoxysilane, benzyl trimethoxysilane, benzyl triethoxysilane, phenethyl trimethoxysilane, hydroxybenzyl trimethoxysilane, hydroxyphenylethyl trimethoxysilane and hydroxyphenylethyl triethoxysilane.

Organosilanes of formula (II) preferably include those wherein R¹ and R⁵ are independently (C₁-C₄)alkyl, benzyl, hydroxybenzyl, phenethyl but not phenyl. Preferably R¹ and R⁵ are methyl, ethyl, tert-butyl, iso-butyl but not phenyl. It is also preferred that b and d are independently 1 or 2. Preferably R³ is (C₁-C₁₀)alkyl, -(CH₂)ₕ-, arylene, arylene ether and -(CH₂)ₕ₁-E-(CH₂)ₕ₂. Suitable compounds of formula (II) include, but are not limited to, those wherein R³ is methylene, ethylene, propylene, butylene, hexylene, norbornylene, cycloheylene, phenylene, phenylene ether, naphthylene and -CH₂-C₆H₄-CH₂-. It is further preferred that c is 1 to 4.

Suitable organosilanes of formula (II) include, but are not limited to, bis(hexamethoxysilyl)methane, bis(hexaethoxysilyl)methane, bis(hexaphenoxysilyl)methane, bis(dimethoxymethylsilyl)methane, bis(diethoxymethylsilyl)methane, bis(dimethoxyphenylsilyl)methane, bis(diethoxyphenylsilyl)methane, bis(methoxydimethylsilyl)methane, bis(ethoxydimethylsilyl)methane, bis(methoxydiphenylsilyl)methane, bis(ethoxydiphenylsilyl)methane, bis(hexamethoxysilyl)ethane, bis(hexaethoxysilyl)ethane, bis(hexaphenoxysilyl)ethane, bis(dimethoxymethylsilyl) ethane, bis(diethoxymethylsilyl)ethane, bis(dimethoxyphenylsilyl)ethane, bis(diethoxyphenyl-silyl)ethane, bis(methoxydimethylsilyl)ethane, bis(ethoxydimethylsilyl)ethane, bis(methoxy-diphenylsilyl)ethane, bis(ethoxydiphenylsilyl)ethane, 1,3-bis(hexamethoxysilyl))propane, 1,3-bis(hexaethoxysilyl)propane, 1,3-bis(hexaphenoxysilyl)propane, 1,3-bis(dimethoxymethylsilyl)propane, 1,3-bis(diethoxymethylsilyl)propane, 1,3-bis(dimethoxyphenylsilyl)propane, 1,3-bis(diethoxyphenylsilyl)propane, 1,3-bis(methoxydimehylsilyl)propane, 1,3-bis(ethoxydimethylsilyl)propane, 1,3-bis(methoxydiphenylsilyl)propane, and 1,3-bis(ethoxydiphenylsilyl)propane. Preferred of these are hexamethoxydisilane, hexaethoxydisilane, hexaphenoxydisilane, 1,1,2,2-tetramethoxy-1,2-dimethyldisilane, 1,1,2,2-tetraethoxy-1,2-dimethyldisilane, 1,1,2,2-tetramethoxy-1,2-diphenyldisilane, 1,1,2,2-tetraethoxy-1,2-diphenyldisilane, 1,2-dimethoxy-1,1,2,2-tetramethyldisilane, 1,2-diethoxy-1,1,2,2-tetramethyldisilane, 1,2-dimethoxy-1,1,2,2-tetraphenyldisilane, 1,2-diethoxy-1,1,2,2-tetraphenyl-disilane, bis(hexamethoxysilyl)methane, bis(hexaethoxysilyl)methane, bis(dimethoxymethylsilyl)methane, bis(diethoxymethylsilyl)methane, bis(dimethoxyphenylsilyl)methane, bis(diethoxyphenylsilyl)methane, bis(methoxydimethylsilyl)methane, bis(ethoxydimethyl-silyl)methane, bis(methoxydiphenylsilyl)methane, and bis(ethoxydiphenylsilyl)methane.

When the B-staged organic polysilica resins include one or more of a hydrolyzate and partial condensate of organosilanes of formula (II), c may be 0, provided that at least one of R¹ and R⁵ are not hydrogen. In an alternate embodiment, the B-staged organic polysilica resins may include one or more of a cohydrolyzate and partial cocondensate of organosilanes of both formulae (I) and (II). In such cohydrolyzates and partial cocondensates, c in formula (II) can be 0, provided that at least one of R, R¹ and R⁵ is not hydrogen. Suitable silanes of formula (II) where c is 0 include, but are not limited to, hexamethoxydisilane, hexaethoxydisilane, hexaphenoxydisilane, 1,1,1,2,2-pentamethoxy-2-methyldisilane, 1,1,1,2,2-pentaethoxy-2-methyldisilane, 1,1,1,2,2-pentamethoxy-2-phenyldisilane, 1,1,1,2,2-pentaethoxy-2-phenyldisilane, 1,1,2,2-tetramethoxy-1,2-dimethyldisilane, 1,1,2,2-tetraethoxy-1,2-dimethyldisilane, 1,1,2,2-tetramethoxy-1,2-diphenyldisilane, 1,1,2,2-tetraethoxy-1,2-diphenyldisilane, 1,1,2-trimethoxy-1,2,2-trimethyldisilane, 1,1,2-triethoxy-1,2,2-trimethyldisilane, 1,1,2-trimethoxy-1,2,2-triphenyldisilane, 1,1,2-triethoxy-1,2,2-triphenyldisilane, 1,2-dimethoxy-1,1,2,2-tetramethyldisilane, 1,2-diethoxy-1,1,2,2-tetramethyldisilane, 1,2-dimethoxy-1,1,2,2-tetraphenyldisilane, and 1,2-diethoxy-1,1,2,2-tetra-phenyldisilane.

In one embodiment, particularly suitable B-staged organic polysilica resins are chosen from one or more of hydrolyzates and partial condensates of compounds of formula (I). Such B-staged organic polysilica resins have the formula (III):

((R⁷R⁸SiO)ₑ(R⁹SiO_{1.5})_{f}(R¹⁰SiO_{1.5})_{g}(SiO₂)ᵣ)ₙ (III)

wherein R⁷, R⁸, R⁹ and R¹⁰ are independently selected from hydrogen, (C₁-C₆)alkyl, (C₇-C₁₂)arylalkyl, substituted (C₇-C₁₂)arylalkyl, aryl, and substituted aryl; e, g and r are independently a number from 0 to 1; f is a number from 0.2 to 1; n is integer from 3 to 10,000; provided that e + f + g + r = 1; and provided that at least one of R⁷, R⁸ and R⁹ is not hydrogen. In the above formula (III), e, f, g and r represent the mole ratios of each component. Such mole ratios can be varied between 0 and 1. It is preferred that e is from 0 to 0.8. It is also preferred that g is from 0 to 0.8. It is further preferred that r is from 0 to 0.8. In the above formula, n refers to the number of repeat units in the B-staged material. Preferably, n is an integer from 3 to 1000.

Suitable organic polysilica resins include, but are not limited to, silsesquioxanes, partially condensed halosilanes or alkoxysilanes such as partially condensed by controlled hydrolysis tetraethoxysilane having number average molecular weight of 500 to 20,000, organically modified silicates having the composition RSiO₃, O₃SiRSiO₃, R₂SiO₂ and O₂SiR₃SiO₂ wherein R is an organic substituent, and partially condensed orthosilicates having Si(OR)₄ as the monomer unit. Silsesquioxanes are polymeric silicate materials of the type RSiO_{1.5} where R is an organic substituent. Suitable silsesquioxanes are alkyl silsesquioxanes such as methyl silsesquioxane, ethyl silsesquioxane, propyl silsesquioxane, butyl silsesquioxane and the like; aryl silsesquioxanes such as phenyl silsesquioxane and tolyl silsesquioxane; alkyl/aryl silsesquioxane mixtures such as a mixture of methyl silsesquioxane and phenyl silsesquioxane; and mixtures of alkyl silsesquioxanes such as methyl silsesquioxane and ethyl silsesquioxane. B-staged silsesquioxane materials include homopolymers of silsesquioxanes, copolymers of silsesquioxanes or mixtures thereof. Such materials are generally commercially available or may be prepared by known methods.

In an alternate embodiment, the organic polysilica resins may contain a wide variety of other monomers in addition to the silicon-containing monomers described above. For example, the organic polysilica resins may further comprise cross-linking agents, and carbosilane moieties. Such cross-linking agents may be any of the cross-linking agents described elsewhere in this specification, or any other known cross-linkers for silicon-containing materials. It will be appreciated by those skilled in the art that a combination of cross-linkers may be used. Carbosilane moieties refer to moieties having a (Si-C)ₓ structure, such as (Si-A)ₓ structures wherein A is a substituted or unsubstituted alkylene or arylene, such as SiR₃CH₂-, -SiR₂CH₂-, =SiRCH₂-, and ≡SiCH₂-, where R is usually hydrogen but may be any organic or inorganic radical. Suitable inorganic radicals include organosilicon, siloxyl, or silanyl moieties. These carbosilane moieties are typically connected "head-to-tail", i.e. having Si-C-Si bonds, in such a manner that a complex, branched structure results. Particularly useful carbosilane moieties are those having the repeat units (SiHₓCH₂) and (SiH_{y-1}(CH=CH₂)CH₂), where x = 0 to 3 and y = 1 to 3. These repeat units may be present in the organic polysilica resins in any number from 1 to 100,000, and preferably from 1 to 10,000. Suitable carbosilane precursors are those disclosed in U.S. Patent Nos. 5,153,295 (Whitmarsh et al.) and 6,395,649 (Wu).

It is preferred that the B-staged organic polysilica resin includes a silsesquioxane, and more preferably methyl silsesquioxane, ethyl silsesquioxane, propyl silsesquioxane, iso-butyl silsesquioxane, tert-butyl silsesquioxane, phenyl silsesquioxane, tolyl silsesquioxane, benzyl silsesquioxane or mixtures thereof. Methyl silsesquioxane, phenyl silsesquioxane and mixtures thereof are particularly suitable. Other useful silsesquioxane mixtures include mixtures of hydrido silsesquioxanes with alkyl, aryl or alkyl/aryl silsesquioxanes. Typically, the silsesquioxanes useful in the present invention are used as oligomeric materials, generally having from 3 to 10,000 repeating units.

Particularly suitable organic polysilica B-staged resins are co-hydrolyzates and partial condensates of one or more organosilanes of formulae (I) and/or (II) and one or more tetrafunctional silanes having the formula SiY₄, where Y is any hydrolyzable group as defined above. Suitable hydrolyzable groups include, but are not limited to, halo, (C₁-C₆)alkoxy, acyloxy and the like. Preferred hydrolyzable groups are chloro and (C₁-C₂)alkoxy. Suitable tetrafunctional silanes of the formula SiY₄ include, but are not limited to, tetramethoxysilane, tetraethoxysilane, tetrachlorosilane, and the like. Particularly suitable silane mixtures for preparing the cohydrolyzates and partial cocondensates include: methyl triethoxysilane and tetraethoxysilane; methyl trimethoxysilane and tetramethoxysilane; phenyl triethoxysilane and tetraethoxysilane; methyl triethoxysilane and phenyl triethoxysilane and tetraethoxysilane; ethyl triethoxysilane and tetramethoxysilane; and ethyl triethoxysilane and tetraethoxysilane. The ratio of such organosilanes to tetrafunctional silanes is typically from 99:1 to 1:99, preferably from 95:5 to 5:95, more preferably from 90:10 to 10:90, and still more preferably from 80:20 to 20:80.

In a particular embodiment, the B-staged organic polysilica resin is chosen from one or more of a co-hydrolyzate and partial co-condensate of one or more organosilanes of formula (I) and a tetrafunctional silane of formula SiY4_{.} In another embodiment, the B-staged organic polysilica resin is chosen from one or more of a co-hydrolyzate and partial co-condensate of one or more organosilanes of formula (II) and a tetrafunctional silane of formula SiY₄. In still another embodiment, the B-staged organic polysilica resin is chosen from one or more of a co-hydrolyzate and partial co-condensate of one or more organosilanes of formula (I), one or more silanes of formula (II) and a tetrafunctional silane of formula SiY₄. The B-staged organic polysilica resins include one or more of a non-hydrolyzed and non-condensed silane of one or more silanes of formulae (I) or (II) with one or more of the hydrolyzate and partial condensate of one or more silanes of formulae (I) or (II). In a further embodiment, the B-staged organic polysilica resin includes a silane of formula (II) and one or more of a hydrolyzate and partial condensate of one or more organosilanes of formula (I), and preferably one or more of a co-hydrolyzate and partial co-condensate of one or more organosilanes of formula (I) with a tetrafunctional silane of the formula SiY4 where Y is as defined above. Preferably, such B-staged organic polysilica resin includes a mixture of one or more silanes of formula (II) and one or more of a co-hydrolyzate and partial co-condensate having the formula (RSiO_{1.5}) (SiO₂) where R is as defined above.

When organosilanes of formula (I) are co-hydrolyzed or co-condensed with a tetrafunctional silane, it is preferred that the organosilane of formula (I) has the formula RSiY₃, and preferably is selected from methyl trimethoxysilane, methyl triethoxysilane, ethyl trimethoxysilane, ethyl triethoxysilane, phenyl trimethoxysilane, phenyl triethoxysilane and mixtures thereof. It is also preferred that the tetrafunctional silane is selected from tetramethoxysilane and tetraethoxysilane.

As discussed, for antireflective applications, suitably one or more of the compounds reacted to form the resin comprise a moiety that can function as a chromophore to absorb radiation employed to expose an overcoated photoresist coating layer. For example, a phthalate compound (e.g. a phthalic acid or dialkyl phthalate (i.e. di-ester such as each ester having 1-6 carbon atoms, preferably a di-methyl or ethyl phthalate) may be polymerized with an aromatic or non-aromatic polyol and optionally other reactive compounds to provide a polyester particularly useful in an antireflective composition employed with a photoresist imaged at sub-200 nm wavelengths such as 193 nm. Similarly, resins to be used in compositions with an overcoated photoresist imaged at sub-300 nm wavelengths or sub-200 nm wavelengths such as 248 nm or 193 nm, a naphthyl compound may be polymerized, such as a naphthyl compound containing one or two or more carboxyl substituents e.g. dialkyl particularly di-C₁₋₆alkyl naphthalenedicarboxylate. Reactive anthracene compounds also are preferred, e.g. an anthracene compound having one or more carboxy or ester groups, such as one or more methyl ester or ethyl ester groups.

As mentioned, preferred antireflective coating compositions of the invention can be crosslinked, e.g. by thermal and/or radiation treatment. For example, preferred antireflective coating compositions of the invention may contain a separate crosslinker component that can crosslink with one ore more other components of the antireflective composition. Generally preferred crosslinking antireflective compositions comprise a separate crosslinker component. Particularly preferred antireflective compositions of the invention contain as separate components: a resin, a crosslinker, and a thermal acid generator compound. Additionally, crosslinking antireflective compositions of the invention preferably can also contain an amine basic additive to promote elimination of footing or notching of the overcoated photoresist layer. Crosslinking antireflective compositions are preferably crosslinked prior to application of a photoresist layer over the antireflective coating layer. Thermal-induced crosslinking of the antireflective composition by activation of the thermal acid generator is generally preferred.

Crosslinking antireflective compositions of the invention preferably comprise an ionic or substantially neutral thermal acid generator, e.g. an ammonium arenesulfonate salt, for catalyzing or promoting crosslinking during curing of an antireflective composition coating layer. Typically one or more thermal acid generators are present in an antireflective composition in a concentration from about 0.1 to 10 percent by weight of the total of the dry components of the composition (all components except solvent carrier), more preferably about 2 percent by weight of the total dry components.

As discussed above, antireflective compositions may suitably contain additional resin component. Suitable resin components may contain chromophore units for absorbing radiation used to image an overcoated resist layer before undesired reflections can occur.

For deep UV applications (i.e. the overcoated resist is imaged with deep UV radiation), a polymer of an antireflective composition preferably will absorb reflections in the deep UV range (typically from about 100 to 300 nm). Thus, the polymer preferably contains units that are deep UV chromophores, i.e. units that absorb deep UV radiation. Highly conjugated moieties are generally suitable chromophores. Aromatic groups, particularly polycyclic hydrocarbon or heterocyclic units, are typically preferred deep UV chromophore, e.g. groups having from two to three to four fused or separate rings with 3 to 8 members in each ring and zero to three N, O or S atoms per ring. Such chromophores include optionally substituted phenanthryl, optionally substituted anthracyl, optionally substituted acridine, optionally substituted naphthyl, optionally substituted quinolinyl and ring-substituted quinolinyls such as hydroxyquinolinyl groups. Optionally substituted anthracenyl groups are particularly preferred for 248 nm imaging of an overcoated resist. Preferred antireflective composition resins have pendant anthracene groups. Preferred resins include those of Formula I as disclosed on page 4 of European Published Application 813114A2 of the Shipley Company.

Preferably resins of antireflective compositions of the invention will have a weight average molecular weight (Mw) of about 1,000 to about 10,000,000 daltons, more typically about 5,000 to about 1,000,000 daltons, and a number average molecular weight (Mn) of about 500 to about 1,000,000 daltons. Molecular weights (either Mw or Mn) of the polymers of the invention are suitably determined by gel permeation chromatography.

The concentration of such a resin component of the coating compositions of the invention may vary within relatively broad ranges, and in general the resin binder is employed in a concentration of from about 50 to 95 weight percent of the total of the dry components of the coating composition, more typically from about 60 to 90 weight percent of the total dry components (all components except solvent carrier).

As discussed above, crosslinking-type coating compositions of the invention also may suitably contain a crosslinker component. A variety of crosslinkers may be employed, including those antireflective composition crosslinkers disclosed in Shipley European Application 542008 incorporated herein by reference. For example, suitable antireflective composition crosslinkers include amine-based crosslinkers such as melamine materials, including melamine resins such as manufactured by Cytec Industries and sold under the tradename of Cymel 300, 301, 303, 350, 370, 380, 1116 and 1130. Glycolurils are particularly preferred including glycolurils available from Cytec Industries. Benzoquanamines and urea-based materials also will be suitable including resins such as the benzoquanamine resins available from Cytec Industries under the name Cymel 1123 and 1125, and urea resins available from Cytec Industries under the names of Powderlink 1174 and 1196. In addition to being commercially available, such amine-based resins may be prepared e.g. by the reaction of acrylamide or methacrylamide copolymers with formaldehyde in an alcohol-containing solution, or alternatively by the copolymerization of N-alkoxymethyl acrylamide or methacrylamide with other suitable monomers.

Suitable substantially neutral crosslinkers include hydroxy compounds, particularly polyfunctional compounds such as phenyl or other aromatics having one or more hydroxy or hydroxy alkyl substitutents such as a C₁₋₈hydroxyalkyl substitutents. Phenol compounds are generally preferred such as di-methanolphenol (C₆H₃(CH₂OH)₂)OH) and other compounds having adjacent (within 1-2 ring atoms) hydroxy and hydroxyalkyl substitution, particularly phenyl or other aromatic compounds having one or more methanol or other hydroxylalkyl ring substituent and at least one hydroxy adjacent such hydroxyalkyl substituent.

It has been found that a substantially neutral crosslinker such as a methoxy methylated glycoluril used in antireflective compositions of the invention can provide excellent lithographic performance properties.

A crosslinker component of antireflective compositions of the invention in general is present in an amount of between about 5 and 50 weight percent of total solids (all components except solvent carrier) of the antireflective composition, more typically in an amount of about 7 to 25 weight percent total solids.

Coating compositions of the invention, particularly for reflection control applications, also may contain additional dye compounds that absorb radiation used to expose an overcoated photoresist layer. Other optional additives include surface leveling agents, for example, the leveling agent available under the tradename Silwet 7604 from Union Carbide, or the surfactant FC 171 or FC 431 available from the 3M Company.

Coating compositions of the invention also may contain one or more photoacid generator compound typically in addition to another acid source such as an acid (e.g. malonic acid) or thermal acid generator compound. In such use of a photoacid generator compound (PAG), the photoacid generator is not used as an acid source for promoting a crosslinking reaction, and thus preferably the photoacid generator is not substantially activated during crosslinking of the coating composition (in the case of a crosslinking coating composition). Such use of photoacid generators is disclosed in U.S. Patent 6,261,743 assigned to the Shipley Company. In particular, with respect to coating compositions that are thermally crosslinked, the coating composition PAG should be substantially stable to the conditions of the crosslinking reaction so that the PAG can be activated and generate acid during subsequent exposure of an overcoated resist layer. Specifically, preferred PAGs do not substantially decompose or otherwise degrade upon exposure of temperatures of from about 140 or 150 to 190°C for 5 to 30 or more minutes.

Generally preferred photoacid generators for such use in antireflective compositions or other coating of the invention include e.g. onium salts such as di(4-tert-butylphenyl)iodonium perfluoroctane sulphonate, halogenated non-ionic photoacid generators such as 1,1-bis[p-chlorophenyl]-2,2,2-trichloroethane, and other photoacid generators disclosed for use in photoresist compositions. For at least some antireflective compositions of the invention, antireflective composition photoacid generators will be preferred that can act as surfactants and congregate near the upper portion of the antireflective composition layer proximate to the antireflective composition/resist coating layers interface. Thus, for example, such preferred PAGs may include extended aliphatic groups, e.g. substituted or unsubstituted alkyl or alicyclic groups having 4 or more carbons, preferably 6 to 15 or more carbons, or fluorinated groups such as C₁₋₁₅alkyl or C₂₋₁₅alkenyl having one or preferably two or more fluoro substituents.

To make a liquid coating composition of the invention, the components of the coating composition are dissolved in a suitable solvent such as, for example, one or more oxyisobutyric acid esters particularly methyl-2-hydroxyisobutyrate as discussed above, ethyl lactate or one or more of the glycol ethers such as 2-methoxyethyl ether (diglyme), ethylene glycol monomethyl ether, and propylene glycol monomethyl ether; solvents that have both ether and hydroxy moieties such as methoxy butanol, ethoxy butanol, methoxy propanol, and ethoxy propanol; esters such as methyl cellosolve acetate, ethyl cellosolve acetate, propylene glycol monomethyl ether acetate, dipropylene glycol monomethyl ether acetate and other solvents such as dibasic esters, propylene carbonate and gamma-butyro lactone.

As discussed above, in certain aspects, a preferred solvent for formulatrion of the underlating Si-composition comprises alcohol groups such as a glycol or lactate e.g. propylene glyocol propyl ether, ethyl lactate or methyl lactate.

The concentration of the dry components of the Si-composition in the solvent will depend on several factors such as the method of application. In general, the solids content of an Si-composition varies from about 0.5 to 20 weight percent of the total weight of the coating composition, preferably the solids content varies from about 2 to 10 weight of the coating composition.

### Optional bottom layers (beneath Si-composition)

As discussed above, a trilayer lithography system may be utilized if desired.

In a preferred trilayer approach, a first organic coating composition maybe applied such as by spin coating on a substrate surface, followed by application (such as by spin coating) of a silicon antireflective coating composition as disclosed herein, and further followed by a photoresist composition.

The organic layer below the silicon antireflective composition may be a variety of materials that do not contain Si content such as a polyacrylate and/or polyester resin, i.e. the bottom layer material may be free of materials that contain silicon. In fact, it can be preferred that the organic bottom layer will exhibit etch rate differentials from the overcoated silicon layer.

### Exemplary photoresist systems

A variety of photoresist compositions can be employed with coating compositions of the invention, including positive-acting and negative-acting photoacid-generating compositions. Photoresists used with antireflective compositions of the invention typically comprise a resin binder and a photoactive component, typically a photoacid generator compound. Preferably the photoresist resin binder has functional groups that impart alkaline aqueous developability to the imaged resist composition.

As discussed above, particularly preferred photoresists for use with antireflective compositions of the invention are chemically-amplified resists, particularly positive-acting chemically-amplified resist compositions, where the photoactivated acid in the resist layer induces a deprotection-type reaction of one or more composition components to thereby provide solubility differentials between exposed and unexposed regions of the resist coating layer. A number of chemically-amplified resist compositions have been described, e.g., in U.S. Pat. Nos. 4,968,581; 4,883,740; 4,810,613; 4,491,628 and 5,492,793, al of which are incorporated herein by reference for their teaching of making and using chemically amplified positive-acting resists. Coating compositions of the invention are particularly suitably used with positive chemically-amplified photoresists that have acetal groups that undergo deblocking in the presence of a photoacid. Such acetal-based resists have been described in e.g. U.S. Patents 5,929,176 and 6,090,526.

The antireflective compositions of the invention also may be used with other positive resists, including those that contain resin binders that comprise polar functional groups such as hydroxyl or carboxylate and the resin binder is used in a resist composition in an amount sufficient to render the resist developable with an aqueous alkaline solution. Generally preferred resist resin binders are phenolic resins including phenol aldehyde condensates known in the art as novolak resins, homo and copolymers or alkenyl phenols and homo and copolymers of N-hydroxyphenyl-maleimides.

Preferred positive-acting photoresists for use with an underlying coating composition of the invention contains an imaging-effective amount of photoacid generator compounds and one or more resins that are selected from the group of:
1) a phenolic resin that contains acid-labile groups that can provide a chemically amplified positive resist particularly suitable for imaging at 248 nm. Particularly preferred resins of this class include: i) polymers that contain polymerized units of a vinyl phenol and an alkyl acrylate, where the polymerized alkyl acrylate units can undergo a deblocking reaction in the presence of photoacid. Exemplary alkyl acrylates that can undergo a photoacid-induced deblocking reaction include e.g. t-butyl acrylate, t-butyl methacrylate, methyladamantyl acrylate, methyl adamantyl methacrylate, and other non-cyclic alkyl and alicyclic acrylates that can undergo a photoacid-induced reaction, such as polymers in U.S. Patents 6,042,997 and 5,492,793, incorporated herein by reference; ii) polymers that contain polymerized units of a vinyl phenol, an optionally substituted vinyl phenyl (e.g. styrene) that does not contain a hydroxy or carboxy ring substituent, and an alkyl acrylate such as those deblocking groups described with polymers i) above, such as polymers described in U.S. Patent 6,042,997, incorporated herein by reference; and iii) polymers that contain repeat units that comprise an acetal or ketal moiety that will react with photoacid, and optionally aromatic repeat units such as phenyl or phenolic groups; such polymers have been described in U.S. Patents 5,929,176 and 6,090,526, incorporated herein by reference.
2) a resin that is substantially or completely free of phenyl or other aromatic groups that can provide a chemically amplified positive resist particularly suitable for imaging at sub-200 nm wavelengths such as 193 nm. Particularly preferred resins of this class include: i) polymers that contain polymerized units of a non-aromatic cyclic olefin (endocyclic double bond) such as an optionally substituted norbornene, such as polymers described in U.S. Patents 5,843,624, and 6,048,664, incorporated herein by reference; ii) polymers that contain alkyl acrylate units such as e.g. t-butyl acrylate, t-butyl methacrylate, methyladamantyl acrylate, methyl adamantyl methacrylate, and other non-cyclic alkyl and alicyclic acrylates; such polymers have been described in U.S. Patent 6,057,083; European Published Applications EP01008913A1 and EP00930542A1; and U.S. pending Patent Application No. 09/143,462, all incorporated herein by reference, and iii) polymers that contain polymerized anhydride units, particularly polymerized maleic anhydride and/or itaconic anhydride units, such as disclosed in European Published Application EP01008913A1 and U.S. Patent 6,048,662, both incorporated herein by reference.
3) a resin that contains repeat units that contain a hetero atom, particularly oxygen and/or sulfur (but other than an anhydride, i.e. the unit does not contain a keto ring atom), and preferable are substantially or completely free of any aromatic units. Preferably, the heteroalicyclic unit is fused to the resin backbone, and further preferred is where the resin comprises a fused carbon alicyclic unit such as provided by polymerization of a norborene group and/or an anhydride unit such as provided by polymerization of a maleic anhydride or itaconic anhydride. Such resins are disclosed in PCT/US01/14914 and U.S. application number 09/567,634.
4) a resin that contains fluorine substitution (fluoropolymer), e.g. as may be provided by polymerization of tetrafluoroethylene, a fluorinated aromatic group such as fluoro-styrene compound, and the like. Examples of such resins are disclosed e.g. in PCT/US99/21912.

Suitable photoacid generators to employ in a positive or negative acting photoresist overcoated over a coating composition of the invention include imidosulfonates such as compounds of the following formula: 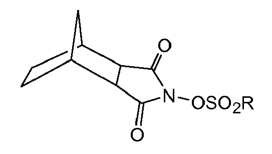 wherein R is camphor, adamantane, alkyl (e.g. C₁₋₁₂ alkyl) and perfluoroalkyl such as perfluoro(C₁₋₁₂alkyl), particularly perfluorooctanesulfonate, perfluorononanesulfonate and the like. A specifically preferred PAG is N-[(perfluorooctanesulfonyl)oxy]-5-norbornene-2,3-dicarboximide.

Sulfonate compounds are also suitable PAGs for resists overcoated a coating composition of the invention , particularly sulfonate salts. Two suitable agents for 193 nm and 248 nm imaging are the following PAGS 1 and 2:

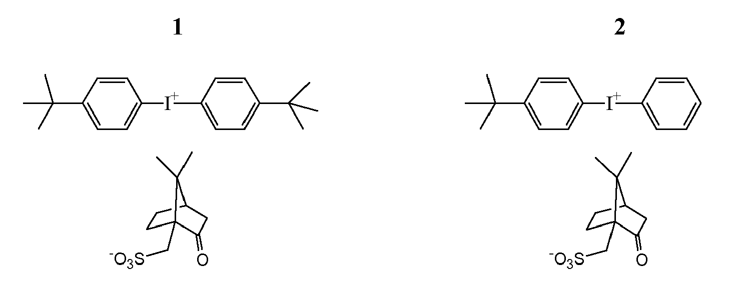

Such sulfonate compounds can be prepared as disclosed in European Patent Application 96118111.2 (publication number 0783136), which details the synthesis of above PAG 1.

Also suitable are the above two iodonium compounds complexed with anions other than the above-depicted camphorsulfonate groups. In particular, preferred anions include those of the formula RSO₃- where R is adamantane, alkyl (e.g. C₁₋₁₂ alkyl) and perfluoroalkyl such as perfluoro (C₁₋₁₂alkyl), particularly perfluorooctanesulfonate, perfluorobutanesulfonate and the like.

Other known PAGS also may be employed in photoresist used with underlaying coating compositions.

A preferred optional additive of photoresists overcoated a coating composition of the invention is an added base, particularly tetrabutylammonium hydroxide (TBAH), or tetrabutylammonium lactate, which can enhance resolution of a developed resist relief image. For resists imaged at 193 nm, a preferred added base is a hindered amine such as diazabicyclo undecene or diazabicyclononene. The added base is suitably used in relatively small amounts, e.g. about 0.03 to 5 percent by weight relative to the total solids.

Preferred negative-acting resist compositions for use with an overcoated coating composition of the invention comprise a mixture of materials that will cure, crosslink or harden upon exposure to acid, and a photoacid generator.

Particularly preferred negative-acting resist compositions comprise a resin binder such as a phenolic resin, a crosslinker component and a photoactive component of the invention. Such compositions and the use thereof have been disclosed in European Patent Applications 0164248 and 0232972 and in U.S. Pat. No. 5,128,232 to Thackeray et al. Preferred phenolic resins for use as the resin binder component include novolaks and poly(vinylphenol)s such as those discussed above. Preferred crosslinkers include amine-based materials, including melamine, glycolurils, benzoguanamine-based materials and urea-based materials. Melamine-formaldehyde resins are generally most preferred. Such crosslinkers are commercially available, e.g. the melamine resins sold by Cytec Industries under the trade names Cymel 300, 301 and 303. Glycoluril resins are sold by Cytec Industries under trade names Cymel 1170, 1171, 1172, Powderlink 1174, and benzoguanamine resins are sold under the trade names of Cymel 1123 and 1125.

Suitable photoacid generator compounds of resists used with antireflective compositions of the invention include the onium salts, such as those disclosed in U.S. Pat. Nos. 4,442,197, 4,603,10, and 4,624,912, each incorporated herein by reference; and non-ionic organic photoactive compounds such as the halogenated photoactive compounds as in U.S. Pat. No. 5,128,232 to Thackeray et al. and sulfonate photoacid generators including sulfonated esters and sulfonlyoxy ketones. See J. of Photopolymer Science and Technology, 4(3):337-340 (1991), for disclosure of suitable sulfonate PAGS, including benzoin tosylate, t-butylphenyl alpha-(p-toluenesulfonyloxy)-acetate and t-butyl alpha(p-toluenesulfonyloxy)-acetate. Preferred sulfonate PAGs are also disclosed in U.S. Pat. No. 5,344,742 to Sinta et al. The above camphorsulfoanate PAGs 1 and 2 are also preferred photoacid generators for resist compositions used with the antireflective compositions of the invention, particularly chemically-amplified resists of the invention.

Photoresists for use with an antireflective composition of the invention also may contain other materials. For example, other optional additives include actinic and contrast dyes, anti-striation agents, plasticizers, speed enhancers, etc. Such optional additives typically will be present in minor concentration in a photoresist composition except for fillers and dyes which may be present in relatively large concentrations such as, e.g., in amounts of from about 5 to 50 percent by weight of the total weight of a resist's dry components.

Various substituents and materials (including resins, small molecule compounds, acid generators, etc.) as being "optionally substituted" may be suitably substituted at one or more available positions by e.g. halogen (F, Cl, Br, I); nitro; hydroxy; amino; alkyl such as C₁₋₈ alkyl; alkenyl such as C₂₋₈ alkenyl; alkylamino such as C₁₋₈ alkylamino; carbocyclic aryl such as phenyl, naphthyl, anthracenyl, etc; and the like.

### Lithographic processing

In use, a coating composition of the invention is applied as a coating layer to a substrate by any of a variety of methods such as spin coating. The coating composition in general is applied on a substrate with a dried layer thickness of between about 0.02 and 0.5 µm, preferably a dried layer thickness of between about 0.04 and 0.20 µm. The substrate is suitably any substrate used in processes involving photoresists. For example, the substrate can be silicon, silicon dioxide or aluminum-aluminum oxide microelectronic wafers. Gallium arsenide, silicon carbide, ceramic, quartz or copper substrates may also be employed. Substrates for liquid crystal display or other flat panel display applications are also suitably employed, for example glass substrates, indium tin oxide coated substrates and the like. Substrates for optical and optical-electronic devices (e.g. waveguides) also can be employed.

Also, as discussed above, Si-compositions can be utilized in trilayer systems, where a further composition coating layer may be applied such as by spin-coating onto a substrate surface followed by application of an Si-composition. Polyacrylates and polyesters coating compositions are suitable materials for such first layers.

Preferably an applied Si-composition coating layer is cured before a photoresist composition is applied over the antireflective composition. Cure conditions will vary with the components of the antireflective composition. Particularly the cure temperature will depend on the specific acid or acid (thermal) generator that is employed in the coating composition. Typical cure conditions are from about 80°C to 225°C for about 0.5 to 40 minutes. Cure conditions preferably render the coating composition coating layer substantially insoluble to the photoresist solvent as well as an alkaline aqueous developer solution.

After such curing, a photoresist is applied above the surface of the top coating composition. As with application of the bottom coating composition layer(s), the overcoated photoresist can be applied by any standard means such as by spinning, dipping, meniscus or roller coating. Following application, the photoresist coating layer is typically dried by heating to remove solvent preferably until the resist layer is tack free. Optimally, essentially no intermixing of the bottom composition layer and overcoated photoresist layer should occur.

The resist layer is then imaged with activating radiation through a mask in a conventional manner. The exposure energy is sufficient to effectively activate the photoactive component of the resist system to produce a patterned image in the resist coating layer. Typically, the exposure energy ranges from about 3 to 300 mJ/cm² and depending in part upon the exposure tool and the particular resist and resist processing that is employed. The exposed resist layer may be subjected to a post-exposure bake if desired to create or enhance solubility differences between exposed and unexposed regions of a coating layer. For example, negative acid-hardening photoresists typically require post-exposure heating to induce the acid-promoted crosslinking reaction, and many chemically amplified positive-acting resists require post-exposure heating to induce an acid-promoted deprotection reaction. Typically post-exposure bake conditions include temperatures of about 50°C or greater, more specifically a temperature in the range of from about 50°C to about 160°C.

As discussed, the photoresist layer also may be exposed in an immersion lithography system, i.e. where the space between the exposure tool (particularly the projection lens) and the photoresist coated substrate is occupied by an immersion fluid, such as water or water mixed with one or more additives such as cesium sulfate which can provide a fluid of enhanced refractive index. Preferably the immersion fluid (e.g., water) has been treated to avoid bubbles, e.g. water can be degassed to avoid nanobubbles.

References herein to "immersion exposing" or other similar term indicates that exposure is conducted with such a fluid layer (e.g. water or water with additives) interposed between an exposure tool and the coated photoresist composition layer.

The exposed resist coating layer is then developed, preferably with an aqueous based developer such as an alkali exemplified by tetra butyl ammonium hydroxide, sodium hydroxide, potassium hydroxide, sodium carbonate, sodium bicarbonate, sodium silicate, sodium metasilicate, aqueous ammonia or the like. Alternatively, organic developers can be used. In general, development is in accordance with art recognized procedures. Following development, a final bake of an acid-hardening photoresist is often employed at temperatures of from about 100°C to about 150°C for several minutes to further cure the developed exposed coating layer areas.

The developed substrate may then be selectively processed on those substrate areas bared of photoresist, for example, chemically etching or plating substrate areas bared of photoresist in accordance with procedures well known in the art. Suitable etchants include a hydrofluoric acid etching solution and a plasma gas etch such as an oxygen plasma etch. A plasma gas etch removes the antireflective coating layer.

In immersion lithography systems, angles of incident exposure radiation can be severe. By use of multiple underlying absorbing layers as disclosed herein, which have differing absorbance levels, to thereby provide a graded absorbance environment, reflection problems arising from incident exposure radiation can be effectively addressed.

The following non-limiting examples are illustrative of the invention.

### GENERAL COMMENTS:

In the following examples, the following abbreviations are employed. List of abbreviations
- PHS/MMA co-polymer: poly(hydroxystyrene/methylmethacrylate) copolymer, 70/30 ratio, 3000 Dalton molecular weight
- UL: organic polymer underlayer coating
- SSQ: silsesquioxane coating composition
- PR: 193 nm ArF photoresist
- PGPE: propylene glycol propyl ether
- PGMEA: propylene glycol monomethyl ether acetate
- Mw: Weight-average molecular weight
- Mn: Number-average molecular weight
- PDI: Polydispersity index
- mJ: milliJoule

### Example 1: Synthesis of Silsesquioxane Resin

Synthetic procedure A. Into an acid washed, oven dried, 500 mL three-necked round-bottom flask under nitrogen purge, fitted with magnetic stirbar, reflux condenser, thermocouple, temperature controller, and heating mantle were added 21.6 grams (100 mmol) phenyltriethoxysilane (Ph), 80.4 grams (450 mmol) methyltriethoxysilane (MTEOS), 17.7 grams (50 mmol) bis(triethoxysilyl)ethane (BTSE), and 36 grams propylene glycol monomethylether acetate (PGMEA). Into a separate flask were added 55.6 grams deionized water and 8.3 g 0.1 N HCl. The water/hydrochloric acid mixture was added to the reaction mixture dropwise. The turbid suspension was stirred until clear (5 minutes). An exotherm of 47 °C was reported. The reaction mixture was stirred for 30 minutes. 83.3 grams (400 mmol) of tetraethylorthosilicate (TEOS) was added dropwise by addition funnel over 40 minutes. The reaction mixture was then heated to reflux for 1 hour. The reaction mixture was cooled to room temperature and diluted by addition of 80 g PGMEA. The reaction mixture was transferred to a 1 L glass bottle, 5 grams of IRN-150 ion exchange resin were added, and the suspension was rolled for 1 hour. The ion exchange resin was removed by filtration. The solution was transferred into a 1 L round-bottom flask and 1 gram of a 5% solids solution of malonic acid in PGMEA was added. Ethanol was distilled from the solution by rotary evaporator under high vacuum at 25 °C. 178.8 grams of distillate were collected. The distillate was discarded. The concentrated reaction mixture was diluted to approximately 20% solids to a final weight of 375 grams. The solution was filtered through a 0.2 micron PTFE membrane filter. The solids concentration of the resin solution was measured by drying 1 gram samples in an oven at 100 °C for 1 hour (23.4% solids). The molecular weight was determined by gel permeation chromatography (GPC): Mw: 3500 Da, Mn: 1600 Da, PDI: 2.2.

### EXAMPLE 2: Synthesis of Silsesquioxane Resin

Synthetic procedure B. Into an acid washed, oven dried, 0.5 L three-necked round-bottom flask under nitrogen purge, fitted with magnetic stirbar, reflux condenser, thermocouple, temperature controller, and heating mantle were added 22.6 grams (100 mmol) phenethyltrimethoxysilane (PhEt), 89.2 grams (500 mmol) methyltriethoxysilane (MTEOS), 83.3 grams (400 mmol) of tetraethylorthosilicate (TEOS), and 36.2 grams propylene glycol monomethylether acetate (PGMEA). Into a separate flask were added 53.3 grams deionized water and 8.02 g 0.1 N HCl. The water/hydrochloric acid mixture was added to the reaction mixture drop-wise. The turbid suspension was stirred until clear (10 minutes). An exotherm of 54 °C was reported. The reaction mixture was stirred for 60 minutes. The reaction mixture was then heated to reflux for 1 hour. The reaction mixture was cooled to room temperature and diluted by addition of 78 g PGMEA. The reaction mixture was transferred to a 1 L glass bottle, 5 grams ofIRN-150 ion exchange resin were added, and the suspension was rolled for 1 hour. The ion exchange resin was removed by filtration. The resin solution was transferred into a 1 L round-bottom flask and 1 gram of a 5% solids solution of malonic acid in PGMEA was added. Ethanol was distilled from the solution by rotary evaporator under high vacuum at 40 °C. 166 grams of distillate were collected. The distillate was discarded. The concentrated reaction mixture was diluted to approximately 20% solids to a final weight of 375 grams. The solution was filtered through a 0.2 micron PTFE membrane filter. The solids concentration of the resin solution was measured by drying 1 gram samples in an oven at 100 °C for 1 hour (23.4% solids). The molecular weight was determined by GPC: Mw: 2600 Da, Mn: 1500 Da, PDI: 1.7.

### EXAMPLES 1 - 14: Resin properties

Si-resins were prepared by process A or B as specified in Examples 1-2 above. The process utilized, monomer feed ratios and the Mw, Mn and polydispersity (PDI) of the resulting polymers (includes the polymers produced in Examples 1 and 2 above as well as 12 additional polymers which are identified as polymrrs of Examples 3 through 14 respectfully in the following Table 1).

**Table 1**

| Example No. | Synthetic Process (Process A or B as specified in Example 1 or 2 respectively) | Resin (monomer feed ratio) | Mw | Mn | PDI |
|---|---|---|---|---|---|
| 1 | A | Ph/MTEOS/BTSE/TEOS | 3500 | 1600 | 2.2 |
| | | 10/45/5/40 | | | |
| 2 | B | PhEt/MTEOS/TEOS 10/50/40 | 2600 | 1500 | 1.7 |
| 3 | A | BTSE/MTEOS/TEOS | 7600 | 2600 | 2.9 |
| | | (5/37/58) | | | |
| 4 | B | PhEt/MTEOS/BTSE/TEOS | 7200 | 2500 | 2.9 |
| | | (5.5/19.2/9.6/65.7) | | | |
| 5 | B | PhEt/MTEOS/BTSE/TEOS | 15200 | 3300 | 4.6 |
| | | (6.0/12.1/21.3/60.6) | | | |
| 6 | B | PhEt/MTEOS/TEOS | 2600 | 1500 | 1.7 |
| | | (10/50/40) | | | |
| 7 | B | PhEt/MTEOS/BTSE/TEOS | 4800 | 2100 | 2.3 |
| | | (5/30/5/60) | | | |
| 8 | B | PhEt/BTSE/TEOS | 26700 | 3500 | 7.7 |
| | | (6/21.3/72.7) | | | |
| 9 | A | PhEt/MTEOS/BTSE/TEOS | 4700 | 2000 | 2.3 |
| | | (5.1/20.5/2.6/71.8) | | | |
| 10 | A | MTEOS/TEOS (54/46) | 7000 | 2500 | 2.8 |
| 11 | B | MTEOS/TEOS (54/46) | 2800 | 1600 | 1.8 |
| 12 | A | Ph/MTEOS/TEOS (5/35/60) | 3700 | 1900 | 1.9 |
| 13 | B | MTEOS/TEOS 35/65 | 4800 | 2200 | 2.2 |
| 14 | B | MTEOS/TEOS 45/55 | 3800 | 1900 | 2.0 |

### Examples 15-20: Silsesquioxane coating compositions

Into a 50 mL plastic bottle were added 3.1 grams of a 20% solids solution of the silsesquioxane resin of example no. 3 (BTSE/MTEOS/TEOS 5/37/58) in PGMEA, 1.1 grams of a 5% solids solution of a commercially available poly(hydroxystyrene/methylmethacrylate) 70/30 copolymer in PGMEA, 0.3 grams of a 5.0% solids solution of malonic acid in PGMEA. The resin mixture was diluted by the addition of 20.5 grams of PGMEA and filtered (0.2 micron PTFE).

Silsesquioxane coating compositions were prepared by mixing the components as set forth in the following Table 2.

**Table 2**

| Example No. | Resin 1 (wt %) | Resin 2 (wt %) | Additive 1 (wt %) | Solvent 1 (wt %) | Solvent 2 (wt %) |
|---|---|---|---|---|---|
| 15 | BTSE/MTEOS/ TEOS 5/37/58 (2.6%) | PHS/MMA co-polymer (0.2%) | malonic acid (0.1%) | PGMEA (97.1%) | none |
| | PhEt/MTEOS/ | | | | |
| 16 | BTSE/TEOS 5.5/19.2/9.6/65.7 | none | malonic acid (0.1%) | PGMEA (96.9%) | nonce none |
| | (3.0%) | | | | |
| | BTSE/MTEOS/ | PhEt/MTEOS/ | | | 1- |
| 17 | TEOS5/37/58 | BTSE/TEOS | malonic | PGMEA | octanol |
| | (0.6%) | 5.5/19.2/9.6/65.7 | acid (0.1%) | (94.9%) | (2%) |
| | | (2.4%) | | | |
| | MTEOS/TEOS | PhEt/MTEOS/ | | | |
| 18 | 54/46 | BTSE/TEOS | none | PGMEA | PGPE |
| | (2.7%) | 5.5/19.2/9.6/65.7 | | (96%) | (1%) |
| | | (0.6%) | | | |
| | MTEOS/TEOS | PHS/MMA co- | malonic | PGMEA | PGPE |
| 19 | (2.7%) | polymer | acid (0.1%) | (56.9%) | (40%) |
| | MTEOS/TEOS | PHS/MMA co- | malonic | PGMEA | |
| 20 | 54/46 | polymer | acid (0.1%) | (96.9%) | none |
| | (2.7%) | (0.3%) | | | |

### EXAMPLE 21 - Lithographic processing; trilayer applications

The silsesquioxane coating compositions described in the above Table 2 may be employed in trilayer lithographic processing schemes as in this Example 21.

An organic poly(acrylate)-based underlayer coating composition was applied to a silicon wafer by spin coating and baked at 240 °C for 60 seconds to achieve a film thickness of 200 nm. To the underlayer-coated silicon wafer was applied the silsesquioxane coating composition described in example no. 15 by spin-coating. The film was baked at 240 °C for 60 seconds to achieve a film thickness of 45 nm. Next, the cured silsesquioxane coating may optionally be primed with hexamethyldisilazane (HMDS) for 60 sec. A commercially available ArF photoresist is applied to the silsesquioxane coating. Spin coating, followed by a 100 °C soft bake for 60 seconds affords a 135 nm thick photoresist coating. To this photoresist coating, a top coat may also be applied to provide for leaching control that is desirable for 193 nm immersion lithographic processes.

Afterwards, the photoresist coating is exposed with 193 nm laser light using an ArF scanner through an appropriate shadow mask, followed by a 100 °C post exposure bake for 60 seconds. The image is developed with a 0.26 N tetramethylammonium hydroxide (TMAH) developer to afford the desired pattern. An evaluation of the lithographic pattern fidelity is described in the following example.

### EXAMPLE 22

The lithographic performance of the various described silsesquioxane coating compositions is evaluated by considering a number of performance factors. By way of example, we consider a trilayer stack formed with an organic polymer underlayer coating, the silsesquioxane coating composition number 17 selected from table 2 above, and a 193 nm ArF photoresist. This trilayer stack is processed according to the procedure described in example 21 above. The patterned photoresist lines (60 nm, 1:1 line/space pattern) demonstrated vertical sidewalls with only a very slight footing at the resist/silsesquioxane coating interface. The silsesquioxane coating in the open (exposed) areas of the patterned wafer is clean from any residual resist scumming.

Defectivity in the silsesquioxane layer of a trilayer stack is unacceptable for advanced lithographic applications. In the present example, we find that scanning electron microscope (SEM) inspection of the silsesquioxane coating in the open (exposed) areas of the patterned wafer does not reveal any coating defects or pits.

Furthermore, we compare the performance of the photoresist coated on top of the described silsesquioxane coating from example number 17 to the performance of the same resist on top of an organic anti-reflective coating in comparative example no. 1. Significant changes in resist performance, such as a change in the photoresist photospeed are indicative of chemical interactions between the resist and the undercoated substrate material. The resist photospeed is the exposure dosage of 193 nm light that is required to form a latent image in the resist of the required dimensions (60 nm, 1:1 line/space pattern). We find that an organic anti-reflective coating is a reliable reference substrate and the photospeed of a resist coated on top of the organic antireflective composition serves as a performance benchmark in this comparison. For trilayer applications, it is desirable that the resist demonstrate minimal interaction with the silsesquioxane substrate coating. In the present example, we find that the photospeed of the resist coated on top of silsesquioxane composition number 17 is comparable to the photospeed of the same resist coated on top of the antireflective composition.

Lastly, we find that the silsesquioxane composition of the present example demonstrates good shelf stability. We define good shelf stability as no appreciable change in the photospeed of the over-coated resist or the resist profile of the processed trilayer upon storage at an elevated temperature (35 °C) over 1 month.

### EXAMPLE 23:

In this example, we consider a trilayer stack formed with an organic polymer underlayer coating, silsesquioxane coating composition from example no. 20, and a 193 nm photoresist and processed according to the procedure described in example 21. The patterned photoresist lines (60 nm, 1:1 line/space pattern) demonstrated vertical sidewalls with slight footing at the resist/silsesquioxane coating interface. The silsesquioxane coating in the open (exposed) areas of the patterned wafer is clean from any residual resist scumming. In the present example, we find that scanning electron microscope (SEM) inspection of the silsesquioxane coating in the open (exposed) areas of the patterned wafer reveals coating defects or pits that are undesirable for trilayer-based lithographic applications.

We find that there is also a significant shift in the photospeed of the resist coated on top of the silsesquioxane coating composition from example no. 20 when compared to the photospeed of the same resist coated on top of the antirdflective composition. This photospeed shift indicates a significant interaction between the silsesquioxane coating and the photoresist. Such interactions are undesirable for trilayer applications.

### COMPARATIVE EXAMPLE 1

In this example, we consider a trilayer stack formed with an organic polymer underlayer coating, an organic anti-reflective coating composition, and a 193 nm photoresist and processed according to the procedure described in example 21. The patterned photoresist lines (60 nm, 1:1 line/space pattern) demonstrate vertical sidewalls with slight footing at the resist/organic anti-reflective coating interface. The organic anti-reflective coating in the open (exposed) areas of the patterned wafer is clean from any residual resist scumming. There are no coating defects or pits observed upon SEM inspection.

The photospeed of the resist in the present example is used as a benchmark for the evaluation of resist/silsesquioxane interactions in examples 22 and 23.

For the purposes of these examples, resist/substrate interaction is defined by the difference in the photospeed of the resist on the antireflective composition and the photospeed of the same resist on the silsesquioxane substrate. We define a photospeed shift of zero to be indicative of zero resist/substrate interaction. We define a photospeed shift of less than 5% to be indicative of a minimal resist/substrate interaction. We define a photospeed shift of greater than 5% to be indicative of a large resist/substrate interaction.

### EXAMPLES 22-23 and COMPARATIVE EXAMPLE 1

Evaluation of lithographic performance

**TABLE 3**

| Example No. | SSQ coating composition in trilayer stack | Patterned resist profile | Resist photo-speed shift (vs. antirflective) | Shelf stability | SSQ coating defectivity |
|---|---|---|---|---|---|
| 22 | Ex. 17 | vertical, | minimal | good | none |
| | | slight foot | | | |
| 23 | Ex.20 | vertical, | large | good | high |
| | | slight foot | | | |
| Comp. Ex. 1 | antireflective | vertical, slight foot | zero | good | none |

## Claims

1. A coated substrate comprising:
a coating composition layer that comprises an organic silicon resin; and
a photoresist composition layer over the coating composition layer;
wherein the organic silicon resin is obtainable by reaction of a Si-containing compound having one or more Si atoms spaced at least 2 or more carbon or hetero atoms from the closest adjacent Si atom or aromatic moiety.

2. The substrate of claim 1 wherein the organic silicon resin comprises phenyl groups.

3. The substrate of claim 1 wherein the Si-containing compound corresponds to the formula aromatic(CH₂)₂₋₈Si(OC₁₋₈alkyl)₃ or (OC₁₋₈alkyl)₃ Si(CH₂)₂₋₈Si(OC₁₋₈ alkyl)₃.

4. The substrate of claim 1 wherein the photoresist composition is a chemically-amplified positive-acting photoresist composition.

5. A method of forming a photoresist relief image, comprising:
applying a coating composition layer on a substrate, the coating composition comprising an organic silicon resin, wherein the organic silicon resin is obtainable by reaction of a Si-containing compound having one or more Si atoms spaced at least 2 or more carbon or hetero atoms from the closest adjacent Si atom or aromatic moiety;
applying a photoresist composition above the coating composition layer; and
exposing and developing the photoresist layer to provide a resist relief image.

6. The method of claim 5 wherein the organic silicon resin comprises phenyl groups.

7. The method of claim 5 wherein the Si-containing compound corresponds to the formula aromatic(CH₂)₂₋₈Si(OC₁₋₈alkyl)₃ or (OC₁₋₈alkyl)₃ Si(CH₂)₂₋₈Si(OC₁₋₈ alkyl)₃.

8. The method of claim 5 wherein the coating composition is formulated with a solvent that comprises hydroxy moieties.

9. The method of claim 5 wherein the photoresist composition is a chemically-amplified positive-acting photoresist composition.

10. A crosslinkable antireflective composition for use with an overcoated photoresist composition, the antireflective composition an organic silicon resin, wherein the organic silicon resin is obtainable by reaction of a Si-containing compound having one or more Si atoms spaced at least 2 or more carbon or hetero atoms from the closest adjacent Si atom or aromatic moiety.
